# EUROPEAN PATENT APPLICATION

(11) **EP 4 671 410 A1**
(43) Date of publication of application: **31.12.2025**
(21) Application number: 24760351.7
(22) Date of filing: 20.02.2024
(51) Int. Cl.: C23C 16/18, C07F 9/90, C07F 9/94, C07F 19/00

(54) **THIN FILM MANUFACTURING METHOD AND THIN FILM FORMING MATERIAL**

(30) Priority: 24.02.2023 JP 2023027200
(71) Applicant: ADEKA CORPORATION, Arakawa-ku Tokyo 116-8554 (JP)
(72) Inventor: OOE, Yoshiki, Tokyo 116-8554 (JP); MITSUI, Chiaki, Tokyo 116-8554 (JP); ENZU, Masaki, Tokyo 116-8554 (JP); NISHIDA, Akihiro, Tokyo 116-8554 (JP)
(74) Representative: Müller-Boré & Partner Patentanwälte PartG mbB
(86) International application number: PCT/JP2024/005979
(87) International publication number: WO 2024/177053

(57) **Abstract**

The present invention provides a method of producing a thin-film and a thin-film forming raw material for forming a bismuth metal thin-film or an antimony metal thin-film by using a compound represented by the following general formula (1) and a compound represented by the following general formula (2). In the general formula (1), M¹ represents trivalent bismuth or trivalent antimony. In the general formula (2), M² represents trivalent bismuth or trivalent antimony, and L¹, L², and L³ each independently represent an alkyl group having 1 or more and 10 or less carbon atoms, a halogen atom, an alkoxy group having 1 or more and 10 or less carbon atoms, or a group represented by the following general formula (3), provided that M¹ and M² represent the same metal atom. In the general formula (3), R¹ and R² each independently represent a hydrogen atom, an alkyl group having 1 or more and 10 or less carbon atoms, or -SiR³R⁴R⁵, R³, R⁴, and R⁵ each independently represent an alkyl group having 1 or more and 10 or less carbon atoms, and * represents a bonding site with M².

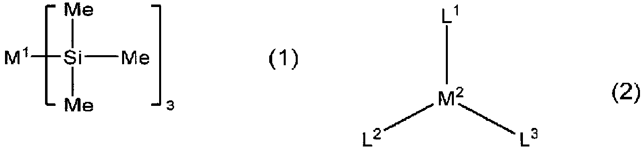

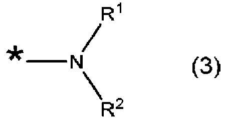

## Description

### Technical Field

The present invention relates to a method of producing a thin-film and to a thin-film forming raw material.

### Background Art

A thin-film containing a Group V element, such as antimony or bismuth, is used for various semiconductor devices, and an atomic layer deposition method has been known as a method of producing such thin-films.

For example, Patent Document 1 discloses a method of producing an antimony oxide thin-film by the atomic layer deposition method. In addition, Patent Document 2 discloses a method of producing a germanium-antimony-tellurium film using an antimony alkoxide and an aminoantimony as a multicomponent film. Further, Patent Document 3 discloses the formation of an antimony metal thin-film using antimony trichloride and tris(triethylsilyl)antimony.

### Citation List

### Patent Document

[Patent Document 1] JP 2013-84959 A
[Patent Document 2] JP 2015-7279 A
[Patent Document 3] JP 2013-508555 A

### Summary of Invention

### Technical Problem

However, in each of Patent Documents 1 and 2, there is no disclosure of a method of producing an antimony metal thin-film.

In addition, the method described in Patent Document 3 has not been sufficient in terms of film formation rate and purity of the antimony metal thin-film. Further, there has been a problem in that although antimony exhibits good reactivity with a dissimilar metal compound, antimony has low reactivity with a similar metal compound.

Moreover, there has been a similar problem with a bismuth atom, which belongs to the same group as an antimony atom, and a method of producing a thin-film, which is capable of forming a high-purity bismuth metal thin-film or antimony metal thin-film with a high film formation rate, a uniform film thickness, and a small residual carbon content, has not been known.

Accordingly, an object of the present invention is to provide: a method of producing a thin-film, which is capable of forming a high-purity bismuth metal thin-film or antimony metal thin-film with a high film formation rate, a uniform film thickness, and a small residual carbon content; and a thin-film forming raw material, which is used in the method of producing a thin-film.

### Solution to Problem

The inventors of the present invention have made extensive investigations to solve the above problems, and as a result, have found that a method of producing a thin-film by using a specific compound as a thin-film forming raw material can solve the above problems. Thus, the inventors have completed the present invention.

That is, this disclosure provides a method of producing a thin-film, including forming a bismuth metal thin-film or an antimony metal thin-film by using a compound represented by the following general formula (1) and a compound represented by the following general formula (2).

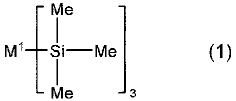

In the general formula (1), M¹ represents trivalent bismuth or trivalent antimony.

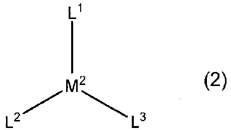

In the general formula (2), M² represents trivalent bismuth or trivalent antimony, and L¹, L², and L³ each independently represent a halogen atom, an alkyl group having 1 or more and 10 or less carbon atoms, an alkoxy group having 1 or more and 10 or less carbon atoms, or a group represented by the following general formula (3), provided that M¹ and M² represent the same metal atom.

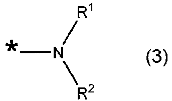

In the general formula (3), R¹ and R² each independently represent a hydrogen atom, an alkyl group having 1 or more and 10 or less carbon atoms, or -SiR³R⁴R⁵, R³, R⁴, and R⁵ each independently represent an alkyl group having 1 or more and 10 or less carbon atoms, and * represents a bonding site with M².

This disclosure provides a thin-film forming raw material set, including: a first thin-film forming raw material containing a bismuth compound or antimony compound represented by the following general formula (1); and a second thin-film forming raw material containing a bismuth compound or antimony compound represented by the following general formula (2).

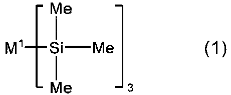

In the general formula (1), M¹ represents trivalent bismuth or trivalent antimony.

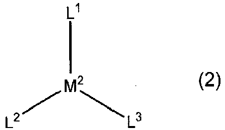

In the general formula (2), M² represents trivalent bismuth or trivalent antimony, and L¹, L², and L³ each independently represent a halogen atom, an alkyl group having 1 or more and 10 or less carbon atoms, an alkoxy group having 1 or more and 10 or less carbon atoms, or a group represented by the following general formula (3), provided that M¹ and M² represent the same metal atom.

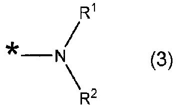

In the general formula (3), R¹ and R² each independently represent a hydrogen atom, an alkyl group having 1 or more and 10 or less carbon atoms, or -SiR³R⁴R⁵, R³, R⁴, and R⁵ each independently represent an alkyl group having 1 or more and 10 or less carbon atoms, and * represents a bonding site with M².

### Advantageous Effects of Invention

This disclosure provides: the method of producing a thin-film, which is capable of forming a high-purity bismuth metal thin-film or antimony metal thin-film with a high film formation rate, a uniform film thickness, and a small residual carbon content; and the thin-film forming raw material, which is used in the method of producing a thin-film.

### Brief Description of Drawings

FIG. 1 is a schematic diagram for illustrating an example of an ALD apparatus to be used in a method of producing a thin-film according to the present invention.
FIG. 2 is a schematic diagram for illustrating another example of the ALD apparatus to be used in the method of producing a thin-film according to the present invention.
FIG. 3 is a schematic diagram for illustrating still another example of the ALD apparatus to be used in the method of producing a thin-film according to the present invention.
FIG. 4 is a schematic diagram for illustrating yet still another example of the ALD apparatus to be used in the method of producing a thin-film according to the present invention.

### Description of Embodiments

A method of producing a thin-film of this disclosure is described below. First, a thin-film forming raw material used in the method of producing a thin-film of this disclosure is described.

### A. Thin-film Forming Raw Material

A thin-film forming raw material set is used as the above thin-film forming raw material. The set includes: a first thin-film forming raw material containing a bismuth compound or antimony compound represented by the general formula (1); and a second thin-film forming raw material containing a bismuth compound or antimony compound represented by the general formula (2).

Each component for forming the above first thin-film forming raw material and second thin-film forming raw material is described.

### A1. Compound represented by General Formula (1)

In this disclosure, the first thin-film forming raw material contains a bismuth compound or antimony compound represented by the general formula (1). In the general formula (1), M¹ represents trivalent bismuth or trivalent antimony. Examples of the compound represented by the general formula (1) include a bismuth compound represented by the following formula No. 1 and an antimony compound represented by the following formula No. 2.

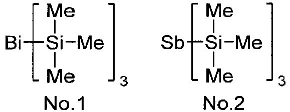

### A2. Compound represented by General Formula (2)

In this disclosure, the second thin-film forming raw material contains a bismuth compound or antimony compound represented by the general formula (2).

M² in the general formula (2) represents trivalent bismuth or trivalent antimony, provided that M² represents the same metal atom as M¹ in the general formula (1).

L¹, L², and L³ in the general formula (2) each represent a halogen atom, an alkyl group having 1 or more and 10 or less carbon atoms, an alkoxy group having 1 or more and 10 or less carbon atoms, or a group represented by the general formula (3).

Examples of the halogen atom represented by each of L¹, L², and L³ in the general formula (2) include a fluorine atom, a chlorine atom, a bromine atom, and an iodine atom.

In this disclosure, a fluorine atom, a chlorine atom, and a bromine atom are preferred, a fluorine atom and a chlorine atom are more preferred, and a chlorine atom is still more preferred.

This is because a high-purity metal thin-film with a high film formation rate, a uniform film thickness, and a small residual carbon content can be formed.

Examples of the alkyl group having 1 or more and 10 or less carbon atoms that is represented by each of L¹, L², and L³ in the general formula (2) include a methyl group, an ethyl group, a n-propyl group, an isopropyl group, a n-butyl group, an isobutyl group, a sec-butyl group, and a tert-butyl group.

In this disclosure, an alkyl group having 1 or more and 4 or less carbon atoms is preferred, an alkyl group having 1 or more and 3 or less carbon atoms is more preferred, and a methyl group or an ethyl group is still more preferred.

This is because a high-purity metal thin-film with a high film formation rate, a uniform film thickness, and a small residual carbon content can be formed.

Examples of the alkoxy group having 1 or more and 10 or less carbon atoms that is represented by each of L¹, L², and L³ in the general formula (2) include a methoxy group, an ethoxy group, a propoxy group, a butoxy group, an isobutoxy group, a sec-butoxy group, a tert-butoxy group, an amyloxy group, an isoamyloxy group, a tert-amyloxy group, and a hexyloxy group.

In this disclosure, an alkoxy group having 1 or more and 7 or less carbon atoms is preferred, and an alkoxy group having 1 or more and 6 or less carbon atoms is more preferred.

This is because a high-purity metal thin-film with a high film formation rate, a uniform film thickness, and a small residual carbon content can be formed.

Examples of the alkyl group having 1 or more and 10 or less carbon atoms that is represented by each of R¹ and R² in the group represented by the general formula (3) that is represented by each of L¹, L², and L³ in the general formula (2) include the same groups as the alkyl groups shown as examples of the alkyl group having 1 or more and 10 or less carbon atoms that is represented by L¹ or the like in the general formula (2).

In this disclosure, R¹ and R² each preferably represent an alkyl group having 1 or more and 4 or less carbon atoms, more preferably represent an alkyl group having 1 or more and 3 or less carbon atoms, and still more preferably represent an alkyl group having 1 or 2 carbon atoms.

This is because a high-purity metal thin-film with a high film formation rate, a uniform film thickness, and a small residual carbon content can be formed.

Examples of the alkyl group having 1 or more and 10 or less carbon atoms that is represented by each of R³, R⁴, and R⁵ in -SiR³R⁴R⁵, which is used as each of R¹ and R² in the general formula (3), include the same groups as the alkyl groups shown as examples of the alkyl group having 1 or more and 10 or less carbon atoms that is represented by L¹ or the like in the general formula (2).

In this disclosure, R³, R⁴, and R⁵ each preferably represent an alkyl group having 1 or more and 4 or less carbon atoms, more preferably represent an alkyl group having 1 or more and 3 or less carbon atoms, and still more preferably represent an alkyl group having 1 or 2 carbon atoms.

This is because a high-purity metal thin-film with a high film formation rate, a uniform film thickness, and a small residual carbon content can be formed.

In this disclosure, L¹, L², and L³ in the general formula (2) may be different from one another or may represent the same group, but it is preferred that L¹, L², and L³ all represent the same group.

This is because a high-purity metal thin-film with a high film formation rate, a uniform film thickness, and a small residual carbon content can be formed.

In this disclosure, when M² in the general formula (2) represents trivalent bismuth, L¹, L², and L³ in the general formula (2) each preferably represent a halogen atom, an alkyl group having 1 or more and 4 or less carbon atoms, an alkoxy group having 1 or more and 10 or less carbon atoms, or a group represented by the general formula (3), more preferably represent a halogen atom, an alkoxy group having 1 or more and 10 or less carbon atoms, or a group represented by the general formula (3), still more preferably represent an alkoxy group having 1 or more and 10 or less carbon atoms or a group represented by the general formula (3), and yet still more preferably represent an alkoxy group having 4 or more and 6 or less carbon atoms, or a group represented by the general formula (3).

This is because a high-purity metal thin-film with a high film formation rate, a uniform film thickness, and a small residual carbon content can be formed.

When M² in the general formula (2) represents trivalent antimony, L¹, L², and L³ in the general formula (2) each preferably represent a halogen atom, an alkyl group having 1 or more and 4 or less carbon atoms, an alkoxy group having 1 or more and 10 or less carbon atoms, or a group represented by the general formula (3), more preferably represent a halogen atom, an alkoxy group having 1 or more and 10 or less carbon atoms, or a group represented by the general formula (3), still more preferably represent a halogen atom, an alkoxy group having 1 or more and 3 or less carbon atoms, or a group represented by the general formula (3), and yet still more preferably represent a chlorine atom, an alkoxy group having 1 or more and 3 or less carbon atoms, or a group represented by the general formula (3).

This is because a high-purity metal thin-film with a high film formation rate, a uniform film thickness, and a small residual carbon content can be formed.

Preferred specific examples of the compound represented by the general formula (2) include Compounds No. 3 to No. 62 below. However, the present invention is not limited to these compounds. In the following chemical formulae, "Me" represents a methyl group, "Et" represents an ethyl group, "nPr" represents a n-propyl group, "iPr" represents an isopropyl group, "nBu" represents a n-butyl group, "sBu" represents a sec-butyl group, and "tBu" represents a tert-butyl group.

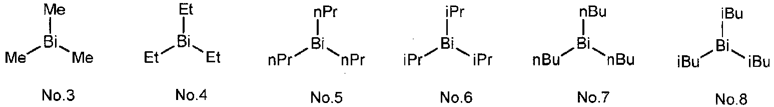

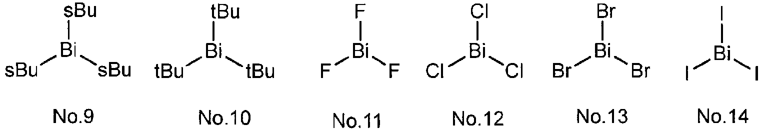

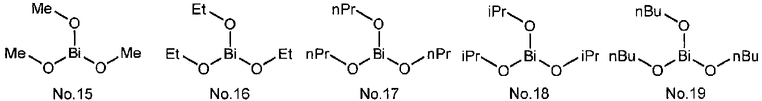

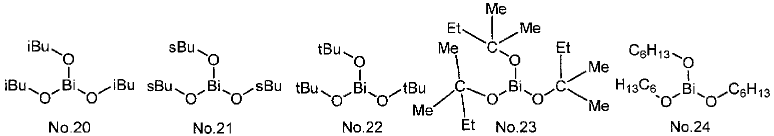

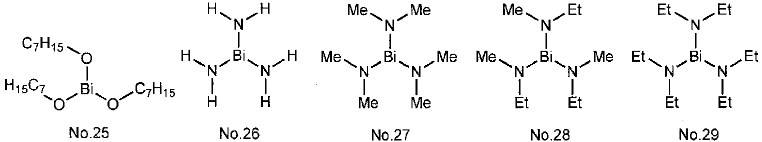

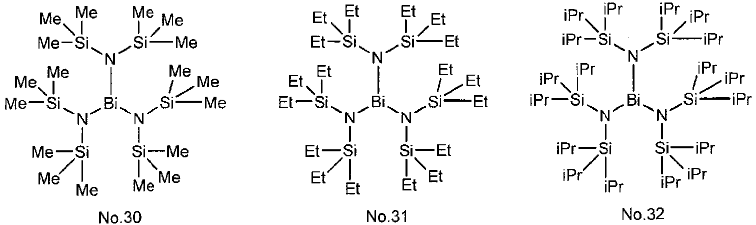

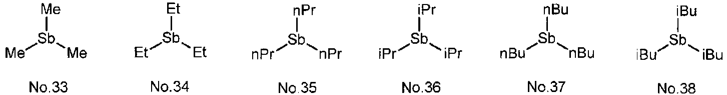

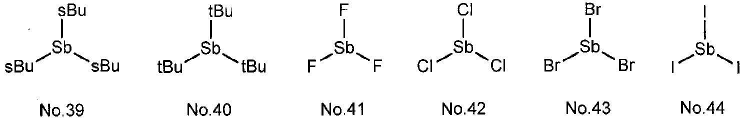

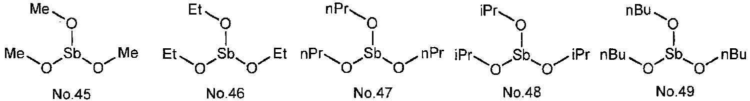

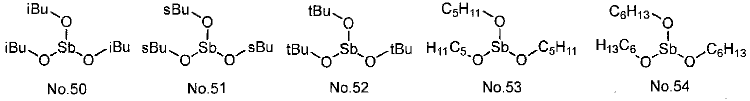

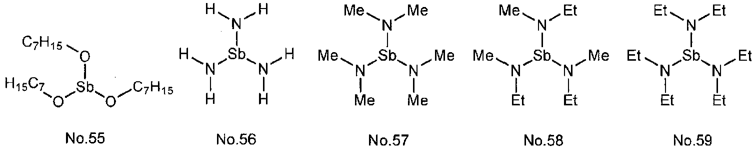

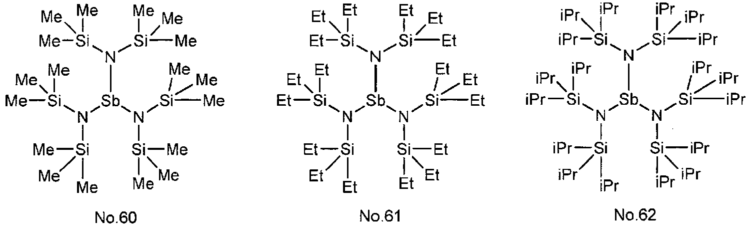

In this step, Compounds No. 12, No. 22, No. 23, No. 24, No. 27, No. 28, No. 42, No. 45, No. 46, No. 47, No. 57, and No. 58 are preferably used, Compounds No. 12, No. 22, No. 23, No. 24, No. 27, No. 28, No. 42, No. 46, and No. 57 are more preferably used, and Compounds No. 23, No. 24, No. 27, No. 28, No. 42, No. 46, and No. 57 are still more preferably used.

This is because a high-purity metal thin-film with a high film formation rate, a uniform film thickness, and a small residual carbon content can be formed.

The molecular weight of the compound represented by the general formula (2) is not limited, but is, for example, preferably 100 or more and 1,000 or less, more preferably 150 or more and 500 or less, still more preferably 200 or more and 490 or less, most preferably 220 or more and 480 or less.

This is because a high-purity metal thin-film with a high film formation rate, a uniform film thickness, and a small residual carbon content can be formed.

### A3. Other Components

The first thin-film forming raw material and second thin-film forming raw material each only need to contain the compound represented by the general formula (1) or the compound represented by the general formula (2), and the composition of each of the thin-film forming raw materials varies depending on the kind of a thin-film to be formed. For example, the thin-film forming raw materials may each contain another component as required. Examples of the other component include another precursor and a nucleophilic reagent.

### (1) Other Precursor

The above other precursor may be a compound different from the compound represented by the general formula (1) and the compound represented by the general formula (2). From the viewpoint that a single metal thin-film is formed, a metal atom for forming the other precursor is preferably the same metal atom as those of the compound represented by the general formula (1) and the compound represented by the general formula (2).

The first and second thin-film forming raw materials may each contain, as the other precursor, a well-known general precursor. Examples of the other precursor include compounds of: one kind or two or more kinds selected from compounds used as organic ligands, such as an alcohol compound, a glycol compound, a β-diketone compound, a cyclopentadiene compound, and an organic amine compound; and a bismuth atom or an antimony atom.

Examples of the alcohol compound to be used as the organic ligand in the other precursor include: alkyl alcohols, such as methanol, ethanol, propanol, isopropyl alcohol, butanol, sec-butyl alcohol, isobutyl alcohol, tert-butyl alcohol, pentyl alcohol, isopentyl alcohol, and tert-pentyl alcohol; ether alcohols, such as 2-methoxyethanol, 2-ethoxyethanol, 2-butoxyethanol, 2-(2-methoxyethoxy)ethanol, 2-methoxy-1-methylethanol, 2-methoxy-1,1-dimethylethanol, 2-ethoxy-1,1-dimethylethanol, 2-isopropoxy-1,1-dimethylethanol, 2-butoxy-1,1-dimethylethanol, 2-(2-methoxyethoxy)-1,1-dimethylethanol, 2-propoxy-1,1-diethylethanol, 2-sec-butoxy-1,1-diethylethanol, and 3-methoxy-1,1-dimethylpropanol; and dialkylamino alcohols, such as dimethylaminoethanol, ethylmethylaminoethanol, diethylaminoethanol, dimethylamino-2-pentanol, ethylmethylamino-2-pentanol, dimethylamino-2-methyl-2-pentanol, ethylmethylamino-2-methyl-2-pentanol, and diethylamino-2-methyl-2-pentanol.

Examples of the glycol compound to be used as the organic ligand in the other precursor include 1,2-ethanediol, 1,2-propanediol, 1,3-propanediol, 2,4-hexanediol, 2,2-dimethyl-1,3-propanediol, 2,2-diethyl-1,3-propanediol, 1,3-butanediol, 2,4-butanediol, 2,2-diethyl-1,3-butanediol, 2-ethyl-2-butyl-1,3-propanediol, 2,4-pentanediol, 2-methyl-1,3-propanediol, 2-methyl-2,4-pentanediol, 2,4-hexanediol, and 2,4-dimethyl-2,4-pentanediol.

Examples of the β-diketone compound to be used as the organic ligand in the other precursor include: alkylsubstituted β-diketones, such as acetylacetone, hexane-2,4-dione, 5-methylhexane-2,4-dione, heptane-2,4-dione, 2-methylheptane-3,5-dione, 5-methylheptane-2,4-dione, 6-methylheptane-2,4-dione, 2,2-dimethylheptane-3,5-dione, 2,6-dimethylheptane-3,5-dione, 2,2,6-trimethylheptane-3,5-dione, 2,2,6,6-tetramethylheptane-3,5-dione, octane-2,4-dione, 2,2,6-trimethyloctane-3,5-dione, 2,6-dimethyloctane-3,5-dione, 2,9-dimethylnonane-4,6-dione, 2-methyl-6-ethyldecane-3,5-dione, and 2,2-dimethyl-6-ethyldecane-3,5-dione; fluorine-substituted alkyl β-diketones, such as 1,1,1-trifluoropentane-2,4-dione, 1,1,1-trifluoro-5,5-dimethylhexane-2,4-dione, 1,1,1,5,5,5-hexafluoropentane-2,4-dione, and 1,3-diperfluorohexylpropane-1,3-dione; and ethersubstituted β-diketones, such as 1,1,5,5-tetramethyl-1-methoxyhexane-2,4-dione, 2,2,6,6-tetramethyl-1-methoxyheptane-3,5-dione, and 2,2,6,6-tetramethyl-1-(2-methoxyethoxy)heptane-3,5-dione.

Examples of the cyclopentadiene compound to be used as the organic ligand in the other precursor include cyclopentadiene, methylcyclopentadiene, ethylcyclopentadiene, propylcyclopentadiene, isopropylcyclopentadiene, butylcyclopentadiene, sec-butylcyclopentadiene, isobutylcyclopentadiene, tert-butylcyclopentadiene, dimethylcyclopentadiene, tetramethylcyclopentadiene, and pentamethylcyclopentadiene.

Examples of the organic amine compound to be used as the organic ligand in the other precursor include methylamine, ethylamine, propylamine, isopropylamine, butylamine, secbutylamine, tert-butylamine, isobutylamine, dimethylamine, diethylamine, dipropylamine, diisopropylamine, ethylmethylamine, propylmethylamine, and isopropylmethylamine.

The other precursors are known in the art, and production methods therefor are also known. As an example of the production method, when the alcohol compound is used as the organic ligand, for example, the other precursor may be produced through a reaction between an inorganic salt of a metal atom that is the same metal atom as that of the compound represented by the general formula (1) or a hydrate of the inorganic salt, and an alkali metal alkoxide of the alcohol compound.

In this case, examples of the inorganic salt of the metal atom or the hydrate thereof may include a halide and a nitrate of a metal.

Examples of the alkali metal alkoxide may include a sodium alkoxide, a lithium alkoxide, and a potassium alkoxide.

In the method of producing a thin-film of this disclosure, when the other precursor is used as the thin-film forming raw material, the other precursor is preferably a compound exhibiting thermal decomposition and/or oxidative decomposition behavior similar to those of the compound represented by the general formula (1) or the compound represented by the general formula (2).

This is because a high-purity metal thin-film with a high film formation rate, a uniform film thickness, and a small residual carbon content can be formed.

In the method of producing a thin-film of this disclosure, when a mixture obtained by mixing the compound represented by the general formula (1) or the compound represented by the general formula (2) and the other precursor is used as the thin-film forming raw material, the other precursor is preferably a compound that exhibits thermal decomposition and/or oxidative decomposition behavior similar to those of the compound represented by the general formula (1) or the compound represented by the general formula (2), and that does not undergo a change through a chemical reaction or the like after being mixed with the compound represented by the general formula (1) or the compound represented by the general formula (2).

This is because a high-purity metal thin-film with a high film formation rate, a uniform film thickness, and a small residual carbon content can be formed.

In the method of producing a thin-film of this disclosure, when the other precursor is incorporated into the thin-film forming raw material, the content of the other precursor is preferably 50 parts by mass or less, more preferably 30 parts by mass or less, still more preferably 10 parts by mass or less, yet still more preferably 5 parts by mass or less, most preferably 0 parts by mass (i.e., the thin-film forming raw material contains no other precursor) in 100 parts by mass of the thin-film forming raw material.

This is because a high-purity metal thin-film with a high film formation rate, a uniform film thickness, and a small residual carbon content can be formed.

### (2) Nucleophilic Reagent

In the method of producing a thin-film of this disclosure, a nucleophilic reagent may be incorporated into each of the first and second thin-film forming raw materials in order to promote a reaction between the metal compound represented by the general formula (1), the metal compound represented by the general formula (2), or the other precursor, and a reducing gas.

Examples of the nucleophilic reagent include: ethylene glycol ethers, such as glyme, diglyme, triglyme, and tetraglyme; crown ethers, such as 18-crown-6, dicyclohexyl-18-crown-6, 24-crown-8, dicyclohexyl-24-crown-8, and dibenzo-24-crown-8; polyamines, such as ethylenediamine, N,N'-tetramethylethylenediamine, diethylenetriamine, triethylenetetramine, tetraethylenepentamine, pentaethylenehexamine, 1,1,4,7,7-pentamethyldiethylenetriamine, 1,1,4,7,10,10-hexamethyltriethylenetetramine, and triethoxytriethyleneamine; cyclic polyamines, such as cyclam and cyclen; heterocyclic compounds, such as pyridine, pyrrolidine, piperidine, morpholine, N-methylpyrrolidine, N-methylpiperidine, N-methylmorpholine, tetrahydrofuran, tetrahydropyran, 1,4-dioxane, oxazole, thiazole, and oxathiolane; β-keto esters, such as methyl acetoacetate, ethyl acetoacetate, and 2-methoxyethyl acetoacetate; and β-diketones, such as acetylacetone, 2,4-hexanedione, 2,4-heptanedione, 3,5-heptanedione, and dipivaloylmethane.

When the first and second thin-film forming raw materials contain the nucleophilic reagent, the content of the nucleophilic reagent is preferably 0.1 mol or more and 10 mol or less, more preferably 1 mol or more and 4 mol or less with respect to 1 mol of the total amount of precursors in the first and second thin-film forming raw materials.

This is because the reaction between the compound represented by the general formula (1), the compound represented by the general formula (2), or the other precursor, and the reducing gas to be described later is easily controlled.

The above total amount of precursors herein refers to the total amount of the compound represented by the general formula (1) or the compound represented by the general formula (2), and the other precursor.

When the first and second thin-film forming raw materials are free of the other precursor, the total amount of precursors refers to the amount of the compound represented by the general formula (1) or the compound represented by the general formula (2).

### (3) Impurities

It is desired that the thin-film forming raw material be prevented from including impurities, such as impurity metal elements, impurity halogens, and impurity organic substances, to the extent possible, except for the above constituents, that is, the compound represented by the general formula (1), the compound represented by the general formula (2), the other precursor, and the nucleophilic reagent for forming the thin-film forming raw material.

Examples of the impurity metal elements include metal elements different from the metal element for forming the compound represented by the general formula (1) or the compound represented by the general formula (2). The content of each of the impurity metal elements in the first and second thin-film forming raw materials is preferably 100 ppm or less, more preferably 10 ppm or less, still more preferably 1 ppm or less in terms of elemental content.

Examples of the impurity halogens include halogen atoms different from the halogen atoms for forming the compound represented by the general formula (2) and the other precursor. The content of each of the impurity halogens in the first and second thin-film forming raw materials is preferably 100 ppm or less, more preferably 10 ppm or less, still more preferably 1 ppm or less.

Examples of the impurity organic substances may include organic substances different from the organic substances for forming the compound represented by the general formula (1), the compound represented by the general formula (2), and the other precursor. The organic substances are formed from carbon and oxygen (excluding carbon monoxide and carbon dioxide), and examples thereof include organic compounds other than the compound represented by the general formula (1), the compound represented by the general formula (2), and the other precursor.

The content of each of the impurity organic substances in the first and second thin-film forming raw materials is preferably 500 ppm or less, more preferably 50 ppm or less, still more preferably 10 ppm or less in terms of total content.

In addition, moisture causes generation of particles in the first and second thin-film forming raw materials, and generation of particles during thin-film formation, and hence it is preferred to remove moisture from each of the compound represented by the general formula (1), the compound represented by the general formula (2), the other precursor, and the nucleophilic reagent in advance at the time of use in order to reduce moisture therein. The moisture content of each of the compound represented by the general formula (1), the compound represented by the general formula (2), the other precursor, and the nucleophilic reagent is preferably 10 ppm or less, more preferably 1 ppm or less.

In addition, it is preferred that the first and second thin-film forming raw materials be each prevented from containing particles to the extent possible in order to reduce or prevent particle contamination of a thin-film to be formed. Specifically, in particle measurement with a light scattering liquid particle detector in a liquid phase, it is preferred that the number of particles larger than 0.3 µm be 100 or less in 1 ml of the liquid phase, and it is more preferred that the number of particles larger than 0.2 µm be 100 or less in 1 ml of the liquid phase.

The physical properties of the compound represented by the general formula (1) or the compound represented by the general formula (2) are also suitable for CVD methods, and hence the above thin-film forming raw materials are useful as chemical vapor deposition raw materials. Of those, the first thin-film forming raw material is particularly suitable for ALD methods because the compound represented by the general formula (1) has a wide ALD window. Accordingly, the first thin-film forming raw material is particularly useful as a thin-film forming raw material for an ALD method.

The set of the first and second thin-film forming raw materials of this disclosure can form a bismuth metal thin-film or antimony metal thin-film excellent in electrical characteristics and optical characteristics. For example, those thin-films are useful as an electrode and a contact layer for various semiconductor devices. The set of the thin-film forming raw materials of this disclosure is particularly useful as a thin-film forming raw material for forming a bismuth metal thin-film or an antimony metal thin-film.

### B. Method of producing Thin-Film

Next, a method of producing a thin-film of this disclosure is described.

This disclosure provides a method of producing a thin-film, including forming a bismuth metal thin-film or an antimony metal thin-film by using a compound represented by the general formula (1) and a compound represented by the general formula (2).

In particular, the method of producing a thin-film of this disclosure preferably involves producing a thin-film by an ALD method.

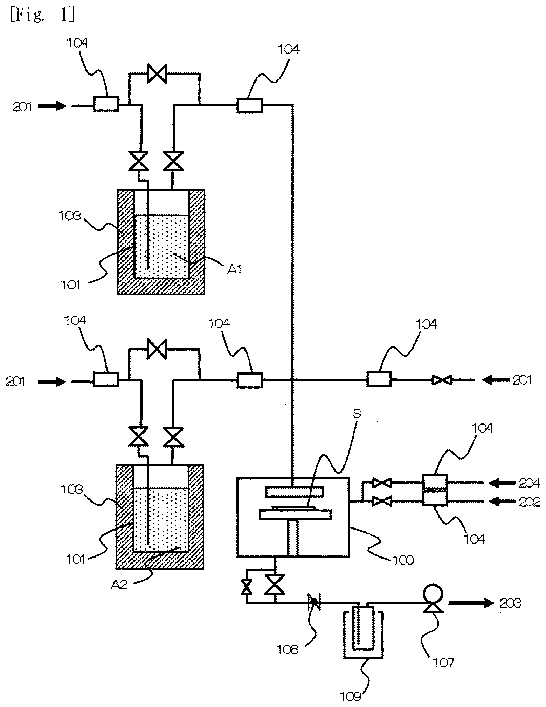

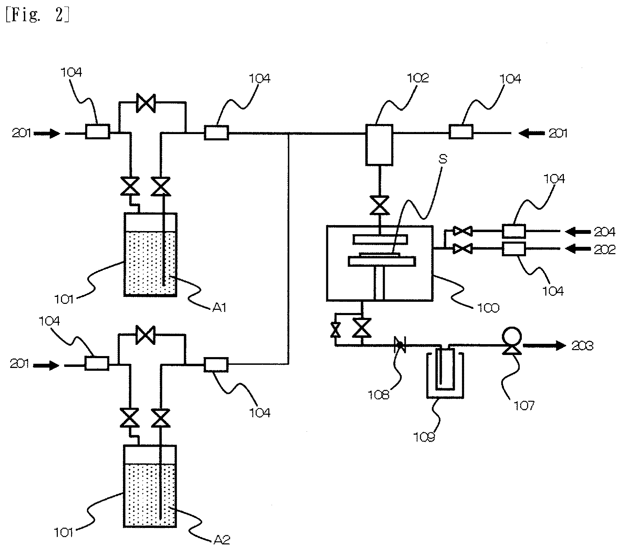

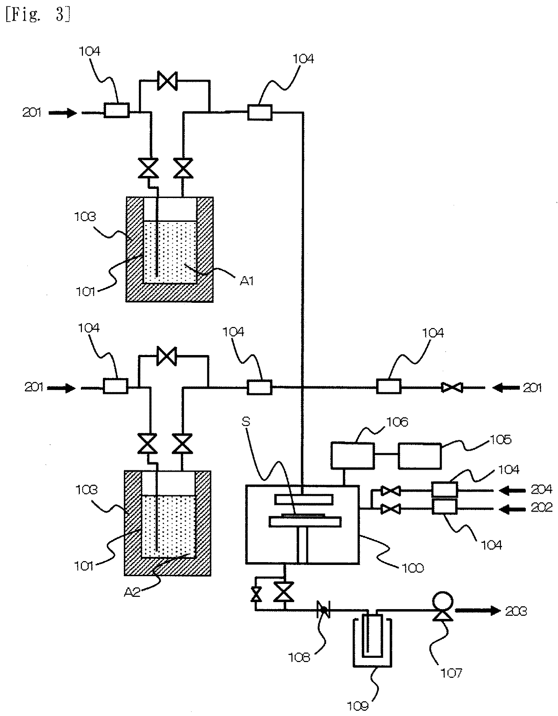

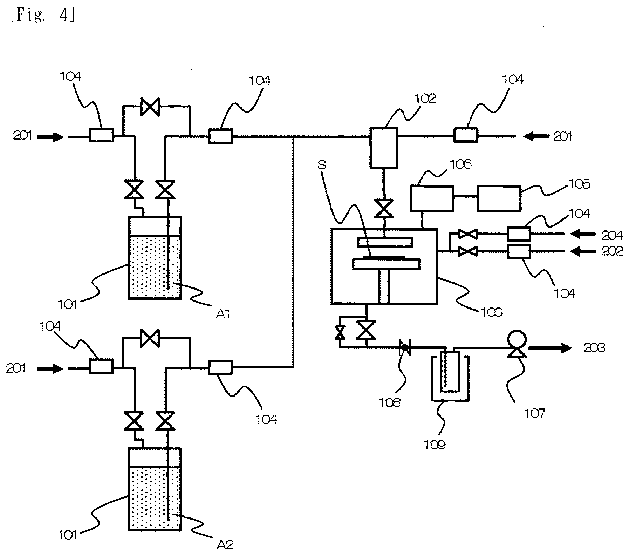

A well-known ALD apparatus may be used as an apparatus used for the method of producing a thin-film of this disclosure. Specific examples of the apparatus include: such an apparatus capable of performing bubbling supply of a precursor as illustrated in each of FIG. 1 and FIG. 3; and such an apparatus including a vaporization chamber 102 as illustrated in each of FIG. 2 and FIG. 4. Another specific example thereof is such an apparatus capable of performing plasma treatment in a film formation chamber 100 as illustrated in each of FIG. 3 and FIG. 4. The apparatus is not limited to such single-substrate type apparatus each including the film formation chamber 100 as illustrated in FIG. 1 to FIG. 4, and an apparatus capable of simultaneously processing a large number of substrates through use of a batch furnace may also be used. Those apparatus may also be used as CVD apparatus.

For example, the method of producing a thin-film by an ALD method of this disclosure includes the steps of: introducing, into a film formation chamber, a first raw material gas obtained by vaporizing a first thin-film forming raw material comprising a bismuth compound or antimony compound represented by the general formula (1), and depositing, onto a surface of a substrate, the compound represented by the general formula (1) in the first raw material gas to form a precursor thin-film; introducing, into the film formation chamber, a second raw material gas obtained by vaporizing a second thin-film forming raw material comprising a bismuth compound or antimony compound represented by the general formula (2), and causing the precursor thin-film and the second raw material gas to react with each other to form a bismuth metal thin-film or an antimony metal thin-film; and introducing, into the film formation chamber, at least one kind of reducing gas selected from the group consisting of: H₂; NH₃; H₂ plasma; and NH₃ plasma, and causing the bismuth metal thin-film or the antimony metal thin-film and the reducing gas to react with each other to highly purify the bismuth metal thin-film or the antimony metal thin-film.

Each step in the method of producing a thin-film by an ALD method of this disclosure is described below with reference to FIG. 1 to FIG. 4.

### B1. Precursor Thin-film Formation Step

In this step, a first raw material gas obtained by vaporizing a first thin-film forming raw material A1 comprising the bismuth compound or antimony compound represented by the general formula (1) is introduced into the film formation chamber 100, and the bismuth compound or antimony compound in the first raw material gas is deposited onto a surface of a substrate S to form a precursor thin-film.

### (1) Substrate

The substrate S is not particularly limited as long as the substrate S can support the precursor thin-film. The substrate S only needs to be a known substrate, and may include an organic compound or an inorganic compound, for example.

Examples of a material for the substrate S include: silicon; ceramics, such as silicon nitride, titanium nitride, tantalum nitride, titanium oxide, molybdenum oxide, zirconium oxide, hafnium oxide, and lanthanum oxide; glass; and metals, such as metal cobalt, metal molybdenum, molybdenum sulfide, molybdenum selenide, tungsten sulfide, and tungsten selenide. The shape of the substrate is, for example, a plate shape, a spherical shape, a fibrous shape, a scaly shape, a plate shape, such as a flat plate or a disc shape, a fibrous shape, a columnar shape, a prismatic shape, a cylindrical shape, a helical shape, a spherical shape, a ring shape, or a three-dimensional structure such as a trench structure.

The thickness of the substrate S is not particularly limited in this disclosure, but is, for example, preferably 1 Å or more and 1 µm or less, preferably 1 Å or more and 50 nm or less.

This is because a high-purity metal thin-film with a high film formation rate, a uniform film thickness, and a small residual carbon content can be formed.

The surface of the substrate S refers to not only a surface of the substrate S such as silicon, but also a surface of the bismuth metal thin-film or the antimony metal thin-film formed through cycles of the method of producing a thin-film to be described later.

### (2) Introduction of First Raw Material Gas

In the method of producing a thin-film of this disclosure, the first raw material gas is obtained by vaporizing the first thin-film forming raw material A1 comprising the bismuth compound or antimony compound represented by the general formula (1).

As a method of obtaining the first raw material gas, there is given, for example, a method including heating and/or decompressing the first thin-film forming raw material A1 comprising the bismuth compound or antimony compound represented by the general formula (1).

As a method of heating the first thin-film forming raw material A1, there are given, for example, a method including heating the thin-film forming raw material in a raw material container 101 of an ALD apparatus illustrated in FIG. 1 or FIG. 3, and a method including heating the thin-film forming raw material in the vaporization chamber 102 in an ALD apparatus illustrated in FIG. 2 or FIG. 4.

The temperature range in which the first thin-film forming raw material A1 is heated is, for example, preferably 300°C or less, more preferably 20°C or more and 250°C or less, still more preferably 30°C or more and 200°C or less.

This is because a high-purity metal thin-film with a high film formation rate, a uniform film thickness, and a small residual carbon content can be formed.

As a method of decompressing the first thin-film forming raw material A1, there are given, for example, a method including decompressing the thin-film forming raw material in the raw material container 101 of the ALD apparatus illustrated in FIG. 1 or FIG. 3, and a method including decompressing the thin-film forming raw material in the vaporization chamber 102 of the ALD apparatus illustrated in FIG. 2 or FIG. 4.

The decompressing (degree of vacuum) condition is, for example, preferably 1 Pa or more and 10,000 Pa or less, more preferably 10 Pa or more and 5,000 Pa or less, still more preferably 20 Pa or more and 1,000 Pa or less.

This is because a high-purity metal thin-film with a high film formation rate, a uniform film thickness, and a small residual carbon content can be formed.

As a method of introducing the first raw material gas into the film formation chamber 100, there are given, for example, a gas transportation method and a liquid transportation method.

An example of the gas transportation method is such a method as illustrated in each of FIG. 1 and FIG. 3 including heating and/or vaporizing the first thin-film forming raw material A1 in the raw material container 101 to provide the first raw material gas, and introducing the first raw material gas into the film formation chamber 100 together with a carrier gas 201, such as argon, nitrogen, or helium, as required.

An example of the liquid transportation method is such a method as illustrated in each of FIG. 2 and FIG. 4 including transporting the first thin-film forming raw material to the vaporization chamber 102 under a state of a liquid or a solution, heating and/or decompressing the first thin-film forming raw material A1 in the vaporization chamber 102 to provide the first raw material gas, and introducing the first raw material gas into the film formation chamber 100 together with the carrier gas 201, such as argon, nitrogen, or helium, as required.

When the first thin-film forming raw material A1 contains the other precursor, the first raw material gas may be introduced into the film formation chamber 100 by using a single source method, for example.

### (3) Formation of Precursor Thin-film

In the precursor thin-film formation step, as described above, the bismuth compound or antimony compound in the first raw material gas introduced into the film formation chamber 100 is deposited onto the surface of the substrate S placed in the film formation chamber 100 in advance to form the precursor thin-film. The term "deposition" in this disclosure represents a concept encompassing a state in which a compound is chemically adsorbed onto the surface of the substrate S.

In this step, it is preferred that any one of the inside of the film formation chamber 100 and the substrate S be heated.

When the metal atom (M¹) of the compound represented by the general formula (1) in the first raw material gas is trivalent bismuth, the first raw material gas is heated at, for example, preferably 25°C or more and 270°C or less, more preferably 25°C or more and 250°C or less, particularly preferably 25°C or more and 230°C or less.

This is because a high-purity metal thin-film with a high film formation rate, a uniform film thickness, and a small residual carbon content can be formed.

When the metal atom (M¹) of the compound represented by the general formula (1) in the first raw material gas is trivalent antimony, the first raw material gas is heated at, for example, preferably 25°C or more and 400°C or less, more preferably 25°C or more and 300°C or less, still more preferably 25°C or more and 250°C or less, yet still more preferably 25°C or more and 200°C or less, most preferably 25°C or more and 150°C or less.

This is because a high-purity metal thin-film with a high film formation rate, a uniform film thickness, and a small residual carbon content can be formed.

In this step, the first raw material gas is preferably heated under a non-oxidizing atmosphere, more preferably heated in an inert gas, such as a nitrogen gas or an argon gas, and is particularly preferably heated under an inert gas atmosphere.

This is because a high-purity uniform metal thin-film is easily formed with a high film formation rate.

In addition, the heating reaction may be performed under any of the following conditions: under increased pressure, under reduced pressure, under normal pressure, and under atmospheric pressure. In this step, however, the heating reaction is preferably performed under reduced pressure (20 Pa or more and 1,000 Pa or less).

This is because a high-purity metal thin-film with a high film formation rate, a uniform film thickness, and a small residual carbon content can be formed.

### B2. Metal Thin-film Formation Step

### (1) Introduction of Second Raw Material Gas

In the method of producing a thin-film of this disclosure, the second raw material gas is obtained by vaporizing a second thin-film forming raw material A2 comprising the bismuth compound or antimony compound represented by the general formula (2).

As a method of obtaining the second raw material gas, the contents of the section "B1 (2) Introduction of First Raw Material Gas" may be applied by replacing the compound represented by the general formula (1) with the compound represented by the general formula (2), and hence the description thereof is omitted here.

However, the compound represented by the general formula (2) may react and decompose when the compound represented by the general formula (2) is brought into contact with the compound represented by the general formula (1). Thus, it is preferred that the first thin-film forming raw material A1 containing the compound represented by the general formula (1) be prevented from being brought into contact with the second thin-film forming raw material A2 containing the compound represented by the general formula (2) by, for example, separately providing supply lines for the thin-film forming raw materials from the raw material container 101 to the film formation chamber 100 in the ALD apparatus illustrated in each of FIG. 1 to FIG. 4.

### (2) Formation of Metal Thin-Film

In the metal thin-film formation step, as described above, the second raw material gas introduced into the film formation chamber 100 and the precursor thin-film are caused to react with each other to form a bismuth metal thin-film or an antimony metal thin-film.

The same conditions as those for the heating of the first raw material gas in the section "B1 (3) Formation of Precursor Thin-film" described above may be applied to the heating of the second raw material gas and the pressure inside the film formation chamber 100 during the heating.

However, when a compound in which all of L¹ to L³ represent dimethylamino groups is used, the heating is performed at preferably 20°C or more and 90°C or less, more preferably 20°C or more and 75°C or less, still more preferably 20°C or more and 60°C or less.

In this step, the reaction between the bismuth compound or antimony compound represented by the general formula (1) in the precursor thin-film and the bismuth compound or antimony compound represented by the general formula (2) in the second raw material gas is promoted by heating the second raw material gas, and the bismuth metal thin-film or the antimony metal thin-film is formed on the substrate.

For example, when Bi(SiMe₃)₃ (Compound No. 1) is used as the compound represented by the general formula (1) and Bi(NMe₂)₃ (Compound No. 27) is used as the compound represented by the general formula (2), the following chemical reaction is caused, and the bismuth metal thin-film is formed on the substrate.

Bi(SiMe₃)₃+Bi(NMe₂)₃→2Bi (Metal)+3(Me₃Si-NMe₂)

In this embodiment, an example in which the first raw material gas is first introduced into the film formation chamber 100 to form the precursor thin-film, and the second raw material gas is then introduced has been described. However, the step of forming the bismuth metal thin-film or the antimony metal thin-film may be performed as described below. The second raw material gas obtained by vaporizing the second thin-film forming raw material A2 is first introduced into the film formation chamber 100. The compound represented by the general formula (2) is deposited onto the surface of the substrate S to form the precursor thin-film. After that, the first raw material gas obtained by vaporizing the first thin-film forming raw material A1 containing the compound represented by the general formula (1) is introduced into the film formation chamber 100, and the precursor thin-film and the first raw material gas are caused to react with each other.

### B3. Metal Thin-film High Purification Step

In this step, at least one kind of reducing gas 202 selected from the group consisting of: H₂; NH₃; H₂ plasma; and NH₃ plasma is introduced into the film formation chamber 100 and caused to react with the bismuth metal thin-film or the antimony metal thin-film to highly purify the bismuth metal thin-film or the antimony metal thin-film.

The high purification step herein refers to a step of increasing the content of the bismuth atom or the antimony atom to be close to 100 parts by mass in 100 parts by mass of the bismuth metal thin-film or the antimony metal thin-film obtained in the previous step.

In the method of producing a thin-film of this disclosure, one kind or two or more kinds selected from the group consisting of: H₂; NH₃; H₂ plasma; and NH₃ plasma may be used in combination as the reducing gas 202.

### (1) H₂

The content of impurities in the H₂ is preferably 10 ppm or less, more preferably 1 ppm or less, particularly preferably 100 ppb or less.

This is because a high-purity metal thin-film with a high film formation rate, a uniform film thickness, and a small residual carbon content can be formed.

Examples of the impurities include H₂O, O₂, CO₂, metals different from M¹ in the general formula (1), and NMHC.

### (2) NH₃

The content of impurities in the NH₃ is preferably 10 ppm or less, more preferably 1 ppm or less, particularly preferably 100 ppb or less.

This is because a high-purity metal thin-film with a high film formation rate, a uniform film thickness, and a small residual carbon content can be formed.

### (3) H₂ Plasma

The H₂ plasma refers to H₂ having H radicals. The H₂ plasma may be produced by, for example, generating plasma from H₂ by using direct current (DC), alternating current (RF), microwaves, or the like. Specifically, as illustrated in FIG. 3 and FIG. 4, a radio frequency (RF) matching system 106 connected to a RF power supply 105 is installed in the film formation chamber 100 to generate plasma in the film formation chamber 100.

### (4) NH₃ Plasma

The NH₃ plasma refers to NH₃ having radicals. The NH₃ plasma may be produced by, for example, causing H₂ and N₂ to react directly with each other by using direct current (DC), alternating current (RF), microwaves, or the like. Specifically, as illustrated in FIG. 3 and FIG. 4, the radio frequency (RF) matching system 106 connected to the RF power supply 105 is installed in the film formation chamber 100 to generate plasma in the film formation chamber 100.

### (5) Other Gas

In the method of producing a thin-film of this disclosure, another gas excluding H₂, NH₃, H₂ plasma, and NH₃ plasma may be incorporated as the reducing gas.

Examples of the other gas include: organic amine compounds, such as a monoalkylamine, a dialkylamine, a trialkylamine, and an alkylenediamine; nitriding gases obtained by vaporizing hydrazine and the like; sulfiding gases, such as sulfur, hydrogen sulfide, and dialkyl sulfides (e.g., dimethyl sulfide, diethyl sulfide, and diisopropyl sulfide); and inert gases, such as argon and nitrogen.

In the method of producing a thin-film of this disclosure, two or more kinds of gases may be mixed and used as the other gas.

In this disclosure, from the viewpoint of easily forming a high-purity metal thin-film with a high film formation rate, a uniform film thickness, and a small residual carbon content, the content of the other gas is preferably 50 vol% or less, more preferably 10 vol% or less, particularly preferably 5 vol% or less in the reducing gas.

In the method of producing a thin-film of this disclosure, the above reducing gas 202 preferably contains only a gas selected from the group consisting of: H₂; NH₃; H₂ plasma; and NH₃ plasma, more preferably contains only a gas selected from the group consisting of: H₂; and H₂ plasma, and particularly preferably contains only H₂ from the viewpoints of high reactivity and suppression of damage to a lower layer.

This is because a high-purity metal thin-film with a high film formation rate, a uniform film thickness, and a small residual carbon content can be formed.

A method of introducing at least one kind selected from the group consisting of: H₂; NH₃; H₂ plasma; and NH₃ plasma into the film formation chamber 100 may be performed by the same method as the method of introducing the first raw material gas or the second raw material gas described above.

However, when H₂ plasma or NH₃ plasma is to be introduced, for example, plasma may be generated by applying a voltage after H₂ or NH₃ is introduced into the film formation chamber 100 illustrated in FIG. 3 or FIG. 4.

The reaction between the metal thin-film and the reducing gas 202 in this step is performed by heating the metal thin-film and/or the reducing gas 202, and the heating in this step is preferably performed at the same temperature as that in the precursor formation step and the metal thin-film formation step.

This is because the metal thin-film with high purity can be efficiently produced.

When the metal thin-film is bismuth metal, the heating is performed at, for example, preferably 25°C or more and 270°C or less, more preferably 25°C or more and 250°C or less, particularly preferably 25°C or more and 230°C or less, for example.

This is because the metal thin-film with high purity can be efficiently produced.

When the metal thin-film is antimony metal, the heating is performed at, for example, preferably 25°C or more and 400°C or less, more preferably 25°C or more and 300°C or less, still more preferably 25°C or more and 250°C or less, yet still more preferably 25°C or more and 200°C or less, most preferably 25°C or more and 150°C or less.

This is because the metal thin-film with high purity can be efficiently produced.

The system pressure is not particularly limited but is preferably 1 Pa or more and 10,000 Pa or less. The system pressure is more preferably 10 Pa or more and 1,000 Pa or less, from the viewpoint of easily and efficiently producing the metal thin-film with high purity.

### B4. Other Steps

The method of producing a thin-film of this disclosure may include exhaust steps 1 to 3, a plasma treatment step, an annealing treatment step, a reflow step, and the like as other steps.

### (1) Exhaust Step 1

This step is performed after the precursor thin-film formation step, and is a step of exhausting (203), from the film formation chamber 100, an unreacted first raw material gas not involved in formation of the precursor thin-film.

In this step, it is ideal that the unreacted first raw material gas be completely exhausted from the film formation chamber 100, but it is not necessarily required that the gas be completely exhausted.

As an exhaust method, there are given, for example: a method including purging the inside of a system of the film formation chamber 100 with an inert gas (purging gas 204), such as helium, nitrogen, or argon; an exhaust method including decompressing the inside of the system while controlling the degree of decompression with a vacuum pump 107 and an automatic pressure controller 108; and a combination of these methods.

The degree of decompression in the case of decompressing the inside of the system is, for example, preferably 0.01 Pa or more and 300 Pa or less, more preferably 0.05 Pa or more and 200 Pa or less, particularly preferably 0.1 Pa or more and 100 Pa or less.

This is because the exhaust of the first raw material gas is sufficient, and a high-purity metal thin-film with a high film formation rate, a uniform film thickness, and a small residual carbon content can be formed.

### (2) Exhaust Step 2

This step is performed after the above metal thin-film formation step, and is a step of exhausting, from the film formation chamber 100, an unreacted second raw material gas not involved in forming the metal thin-film and a by-product gas generated through the reaction between the precursor thin-film and the second raw material gas.

In this step, it is ideal that the unreacted second raw material gas and the by-product gas be completely exhausted from the film formation chamber 100, but it is not necessarily required that the gases be completely exhausted.

The same conditions as those in the exhaust step 1 may be applied to the exhaust method and the degree of decompression in the exhaust step 2.

### (3) Exhaust Step 3

This step is performed after the above metal thin-film high purification step, and is a step of exhausting, from the film formation chamber, an unreacted reducing gas and a by-product gas generated when the metal thin-film is reduced.

In this step, it is ideal that the unreacted reducing gas 202 and the by-product gas be completely exhausted from the film formation chamber 100, but it is not necessarily required that the gases be completely exhausted.

The same conditions as those in the exhaust step 1 may be applied to the exhaust method and the degree of decompression in the exhaust step 3.

### (4) Plasma Treatment Step

The method of producing a thin-film of this disclosure may include the plasma treatment step of applying a voltage to the first raw material gas or the second raw material gas to generate plasma, in order to promote formation of the precursor thin-film and formation of the metal thin-film.

In this step, as illustrated in FIG. 3 and FIG. 4, the radio frequency (RF) matching system 106 connected to the RF power supply 105 may be installed in the film formation chamber 100 to generate plasma from the first raw material gas and the second raw material gas in the film formation chamber 100. When the electrical power used to apply the voltage is too large, damage to the substrate supporting the precursor thin-film or the metal thin-film increases. Thus, the electrical power used to apply the voltage is, for example, preferably 10 W or more and 1,500 W or less, more preferably 30 W or more and 1,000 W or less, still more preferably 50 W or more and 600 W or less.

### (5) Annealing Treatment Step

The annealing treatment step is performed after high purification of the metal thin-film, and may be a step of subjecting the metal thin-film to annealing treatment in order to achieve more satisfactory electrical characteristics of the metal thin-film.

In the annealing treatment step, the metal thin-film may be subjected to the annealing treatment under an inert atmosphere or a reducing atmosphere.

When the metal thin-film is the bismuth metal thin-film, for example, a temperature in the annealing treatment is preferably 100°C or more and 270°C or less, more preferably 150°C or more and 260°C or less, particularly preferably 200°C or more and 250°C or less.

When the metal thin-film is the antimony metal thin-film, for example, a temperature in the annealing treatment is preferably 100°C or more and 630°C or less, more preferably 150°C or more and 550°C or less, still more preferably 200°C or more and 500°C or less.

This is because a high-purity metal thin-film with a high film formation rate, a uniform film thickness, and a small residual carbon content can be formed.

### (6) Reflow Step

The reflow step is performed after formation of the metal thin-film, and may be a step of heating the metal thin-film for step embedding of the metal thin-film.

A temperature in the reflow step is, for example, preferably 200°C or more and 600°C or less, more preferably 230°C or more and 550°C or less, particularly preferably 250°C or more and 500°C or less.

This is because a high-purity metal thin-film with a high film formation rate, a uniform film thickness, and a small residual carbon content can be formed.

### B5. Film Formation Cycle

The method of producing a thin-film of this disclosure sequentially includes the precursor thin-film formation step, the exhaust step 1, the metal thin-film formation step, the exhaust step 2, the high purification step, and the exhaust step 3. The formation of the thin-film through the series of operations is defined as one cycle, and the cycle is repeated until a thin-film of a metal layer having a required film thickness is obtained. Thus, the thin-film of the metal layer having a desired film thickness can be produced. That is, the film thickness of the thin-film to be formed may be controlled by the number of cycles. For example, one layer of the metal thin-film may be formed by performing the cycle once, or the metal thin-film having a desired film thickness may be produced by performing the cycle two or more times.

The film thickness of the thin-film obtained per cycle is preferably 0.1 Å or more and 1.0 nm or less, more preferably 0.3 Å or more and 0.5 nm or less, particularly preferably 0.5 Å or more and 0.1 nm or less.

This is because a metal thin-film having a uniform film thickness is easily obtained.

### B6. Method of producing Thin-film by Method other than ALD Method

In this embodiment, the method of producing the bismuth metal thin-film or the antimony metal thin-film by the ALD method has been described. However, the method of producing a thin-film of this disclosure is not limited to the above method, and the thin-film may be produced by a CVD method, for example.

When the method of producing a thin-film of this disclosure involves production of the thin-film by using the CVD method, the first raw material gas and the second raw material gas may be simultaneously introduced into the film formation chamber 100.

The bismuth metal thin-film or the antimony metal thin-film produced by the method of producing a thin-film of this disclosure contains 90 parts by mass or more of the bismuth atom or the antimony atom in 100 parts by mass of the thin-film.

In this disclosure, the content of the bismuth atom or the antimony atom is preferably 96 parts by mass or more, more preferably 97 parts by mass or more, still more preferably 98 parts by mass or more, yet still more preferably 99 parts by mass or more in 100 parts by mass of the thin-film.

This is because the bismuth metal thin-film and the antimony metal thin-film exhibit excellent electrical characteristics and may be used for various semiconductor devices.

In addition, each of a residual carbon content and a residual oxygen content in the thin-film is preferably small, and is preferably 5 atom% or less, more preferably 3 atom% or less, still more preferably 1 atom% or less.

This is because the thin-film exhibiting excellent electrical characteristics and available for various semiconductor devices can be obtained.

Examples of the semiconductor devices include a field-effect transistor (FET), a nanosheet transistor, a nanowire transistor, and a complementary field-effect (FET) transistor.

In this disclosure, the semiconductor device is preferably a FET having a transition metal dichalcogenide, such as MoS₂, MoSe₂, WS₂, or WSe₂, in a semiconductor layer. The thin-film forming raw material of this disclosure is preferably formed as a contact or a metal thin-film above or below a transition metal dichalcogenide semiconductor layer.

This is because the bismuth metal thin-film and the antimony metal thin-film produced by the method of producing a thin-film of this disclosure are excellent in electrical characteristics.

In addition, the semiconductor device may further include another layer (e.g., an insulator layer, a conductor layer, a semiconductor layer, a buffer layer, or another intermediate layer) or the like.

### Examples

### [Example 1]

A thin-film was produced on a silicon substrate serving as the substrate S by using Bismuth Compound No. 1 (first thin-film forming raw material A1) as the compound represented by the general formula (1) and using Bismuth Compound No. 23 (second thin-film forming raw material A2) as the compound represented by the general formula (2) with the ALD apparatus illustrated in FIG. 1 under the following conditions.

When the composition of the resultant thin-film was analyzed by X-ray diffractometry and X-ray photoemission spectroscopy, the thin-film was a bismuth metal thin-film, and a residual carbon content was 1.0 atom% and a residual oxygen content was 1.0 atoms% in the thin-film.

In addition, when the film thickness of the thin-film was measured by X-ray reflectometry or spectroscopic ellipsometry, the thin-film formed on the substrate was a flat and smooth film having a film thickness of 600 Å, and a film thickness obtained per cycle was 0.6 Å. It can be generally said that the film formation rate is high when the film thickness obtained per cycle is 0.5 Å or more.

An apparatus manufactured by Rigaku Corporation was used for X-ray reflectometry, and an apparatus manufactured by J. A. Woollam Japan Corp. was used for spectroscopic ellipsometry.

### (Conditions)

| | |
|---|---|
| Reaction temperature (substrate temperature): | 200°C (step 1 to step 6) |
| Reducing gas: | H₂ |
| Substrate: substrate | Silicon |

### (Steps)

A series of steps including the following steps 1 to 6 was defined as one cycle, and the cycle was repeated 1,000 times.

Step 1: Vapor of the first thin-film forming raw material A1 (first raw material gas) obtained by vaporization under the conditions of a temperature for heating the raw material container 101 of 80°C and an internal pressure of the raw material container 101 of 100 Pa is introduced into the film formation chamber 100, and the bismuth compound in the first raw material gas is adsorbed onto the surface of the substrate S at a system pressure of 100 Pa for 15 seconds, to thereby form a precursor thin-film.

Step 2: The first raw material gas that has not been adsorbed is exhausted from the system through argon purging for 10 seconds.

Step 3: Vapor of the second thin-film forming raw material A2 (second raw material gas) obtained by vaporization under the conditions of a temperature for heating the raw material container 101 of 100°C and an internal pressure of the raw material container 101 of 100 Pa is introduced into the film formation chamber 100, and is caused to react with the precursor thin-film formed in the step 1 at a system pressure of 100 Pa for 15 seconds.

Step 4: The unreacted second raw material gas and a by-product gas are exhausted from the system through argon purging for 10 seconds.

Step 5: The reducing gas 202 is introduced into the film formation chamber 100 and is caused to react with the bismuth metal thin-film formed in the step 3 at a system pressure of 100 Pa for 15 seconds to highly purify the bismuth metal thin-film.

Step 6: The unreacted reducing gas 202 and a by-product gas are exhausted from the system through argon purging for 10 seconds.

### [Example 2]

A thin-film was produced by using Antimony Compound No. 2 (first thin-film forming raw material A1) as the compound represented by the general formula (1) and using Antimony Compound No. 46 (second thin-film forming raw material A2) as the compound represented by the general formula (2) with the ALD apparatus illustrated in FIG. 1 by the same method as in Example 1 except that the temperature for heating the raw material container 101 in the step 3 was changed to 45°C.

When the composition of the obtained thin-film was analyzed by X-ray diffractometry and X-ray photoemission spectroscopy, the thin-film was an antimony metal thin-film, and a residual carbon content was 1.0 atom% and a residual oxygen content was 1.0 atoms% in the thin-film.

In addition, when the film thickness of the thin-film was measured by X-ray reflectometry or spectroscopic ellipsometry, the thin-film formed on the substrate S was a flat and smooth film having a film thickness of 500 Å, and a film thickness obtained per cycle was 0.5 Å.

### [Comparative Example 1]

A thin-film was produced by using Bismuth Compound No. 1 as the compound represented by the general formula (1) and using triphenylbismuth serving as a comparative compound of the compound represented by the general formula (2) with the ALD apparatus illustrated in FIG. 1 by the same method as in Example 1 except that the temperature for heating the raw material container 101 in the step 3 was changed to 180°C. However, no bismuth metal was generated, and a bismuth metal thin-film could not be formed.

### [Comparative Example 2]

A thin-film was produced by using Antimony Compound No. 2 as the compound represented by the general formula (1) and using triphenylantimony serving as a comparative compound of the compound represented by the general formula (2) with the ALD apparatus illustrated in FIG. 1 by the same method as in Example 1 except that the reaction temperature (substrate temperature) was changed to 220°C and the temperature for heating the raw material container 101 in the step 3 was changed to 160°C. However, no antimony metal was generated, and an antimony metal thin-film could not be formed.

**Table 1**

| | Formula (1) | Formula (2) | Kind of thin-film | Film formation rate | Residual content |
|---|---|---|---|---|---|
| Example 1 | No. 1 | No. 23 | Bismuth | 0.6 Å/cycle | Residual C: 1 atom% Residual O: 1 atom% |
| Example 2 | No. 2 | No. 46 | Antimony | 0.5 Å /cycle | Residual C: 1 atom% Residual C: 1 atom% |
| Compara tive Example 1 | No. 1 | Triphen ylbismu th | Bismuth | No film formation (0 Å/cycle) | No film formation |
| Compara tive Example 2 | No. 2 | Triphen ylantim ony | Antimony | No film formation (0 Å/cycle) | No film formation |

As described above, it was recognized that a high-purity metal thin-film with a high film formation rate, a uniform film thickness, and a small residual carbon content was able to be formed by the method of producing a thin film of the present invention. In addition, the film thickness obtained per cycle of the bismuth metal thin-film or the antimony metal thin-film produced by the method of producing a thin-film of the present invention was significantly large, and hence it was suggested that the method of producing a thin-film of the present invention was able to achieve high productivity.

### Reference Signs List

100 film formation chamber
101 raw material container
102 vaporization chamber
103 heater
104 mass flow controller (MFC)
105 radio frequency (RF) power supply
106 RF matching system
107 vacuum pump
108 automatic pressure controller
109 cooling trap
201 carrier gas
202 reducing gas
203 exhaust
204 purging gas
A1 first thin-film forming raw material
A2 second thin-film forming raw material
S substrate

## Claims

1. A method of producing a thin-film, comprising forming a bismuth metal thin-film or an antimony metal thin-film by using:
a compound represented by the following general formula (1) : 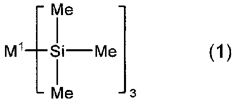
wherein M¹ represents trivalent bismuth or trivalent antimony; and
a compound represented by the following general formula (2) : 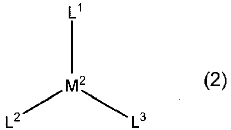
wherein M² represents trivalent bismuth or trivalent antimony, and L¹, L², and L³ each independently represent a halogen atom, an alkyl group having 1 or more and 10 or less carbon atoms, an alkoxy group having 1 or more and 10 or less carbon atoms, or a group represented by the following general formula (3), provided that M¹ and M² represent the same metal atom: 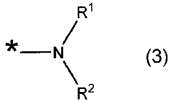
wherein R¹ and R² each independently represent a hydrogen atom, an alkyl group having 1 or more and 10 or less carbon atoms, or -SiR³R⁴R⁵, R³, R⁴, and R⁵ each independently represent an alkyl group having 1 or more and 10 or less carbon atoms, and * represents a bonding site with M².

2. The method of producing a thin-film according to claim 1, comprising the steps of:
introducing, into a film formation chamber, a first raw material gas obtained by vaporizing a first thin-film forming raw material comprising a bismuth compound or antimony compound represented by the general formula (1), and depositing, onto a surface of a substrate, the bismuth compound or the antimony compound in the first raw material gas to form a precursor thin-film;
introducing, into the film formation chamber, a second raw material gas obtained by vaporizing a second thin-film forming raw material comprising a bismuth compound or antimony compound represented by the general formula (2), and causing the precursor thin-film and the second raw material gas to react with each other to form a bismuth metal thin-film or an antimony metal thin-film; and
introducing, into the film formation chamber, at least one kind of reducing gas selected from the group consisting of: H₂; NH₃; H₂ plasma; and NH₃ plasma, and causing the bismuth metal thin-film or the antimony metal thin-film and the reducing gas to react with each other to highly purify the bismuth metal thin-film or the antimony metal thin-film.

3. The method of producing a thin-film according to claim 1, comprising the steps of:
introducing, into a film formation chamber, a second raw material gas obtained by vaporizing a second thin-film forming raw material comprising a bismuth compound or antimony compound represented by the general formula (2), and depositing, onto a surface of a substrate, the bismuth compound or the antimony compound in the second raw material gas to form a precursor thin-film;
introducing, into the film formation chamber, a first raw material gas obtained by vaporizing a first thin-film forming raw material comprising a bismuth compound or antimony compound represented by the general formula (1), and causing the precursor thin-film and the first raw material gas to react with each other to form a bismuth metal thin-film or an antimony metal thin-film; and
introducing, into the film formation chamber, at least one kind of reducing gas selected from the group consisting of: H₂; NH₃; H₂ plasma; and NH₃ plasma, and causing the bismuth metal thin-film or the antimony metal thin-film and the reducing gas to react with each other to highly purify the bismuth metal thin-film or the antimony metal thin-film.

4. A thin-film forming raw material set, comprising:
a first thin-film forming raw material containing a compound represented by the following general formula (1): 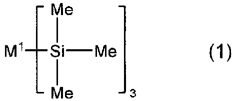
in the general formula (1), M¹ represents trivalent bismuth or trivalent antimony; and
a second thin-film forming raw material containing a compound represented by the following general formula (2): 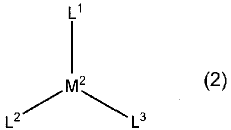
in the general formula (2), M² represents trivalent bismuth or trivalent antimony, and L¹, L², and L³ each independently represent a halogen atom, an alkyl group having 1 or more and 10 or less carbon atoms, an alkoxy group having 1 or more and 10 or less carbon atoms, or a group represented by the following general formula (3), provided that M¹ and M² represent the same metal atom: 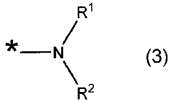
in the general formula (3), R¹ and R² each independently represent a hydrogen atom, an alkyl group having 1 or more and 10 or less carbon atoms, or -SiR³R⁴R⁵, R³, R⁴, and R⁵ each independently represent an alkyl group having 1 or more and 10 or less carbon atoms, and * represents a bonding site with M².

5. The thin-film forming raw material set according to claim 4, wherein the thin-film forming raw material set is used for forming a metal thin-film.
